# EUROPEAN PATENT APPLICATION

(11) **EP 1 235 348 A1**
(43) Date of publication of application: **28.08.2002**
(21) Application number: 01103429.5
(22) Date of filing: 14.02.2001
(51) Int. Cl.: H03K 3/2893

(54) **Hysteresis circuit**

(71) Applicant: Siemens Aktiengesellschaft, 80333 München (DE)
(72) Inventor: Dünnebacke, Joachim, Ing.-grad., 35745 Herborn (DE); Schnabel, Steffen, Dipl.-Ing., 35444 Biebertal (DE)

(57) **Abstract**

Comparator circuit and voltage level detector comprising such comparator circuit including a first operational amplifier having a diffferential input, first and second voltage dividers being coupled to respectively a variable and a constant voltage source, outputs thereof being coupled to said differential input for supplying a differential input voltage thereto, the first operational amplifier having an output being coupled to its differential input and providing an output voltage stepwise varying between first and second voltage levels at an inversion of the differential input voltage. In order to lower power consumption and increase the accuracy of level detection, one of the first and second voltage dividers is being provided with a stepwise variable voltage dividing factor, which is controlled by the output voltage of the first operational amplifier to increase the magnitude of said differential input voltage by a step value upon such inversion of the differential input voltage.

## Description

The invention relates to a comparator circuit comprising a first operational amplifier having a differential input, first and second voltage dividers being coupled to respectively a variable and a constant voltage source, outputs thereof being coupled to said differential input for supplying a differential input voltage thereto, the first operational amplifier having an output being coupled to its differential input and providing an output voltage stepwise varying between first and second voltage levels at an inversion of the differential input voltage. Such comparator circuit is on itself known e.g. as Schmitt trigger, and is to compare an input voltage with a reference voltage, therewith operating as a voltage level detector.

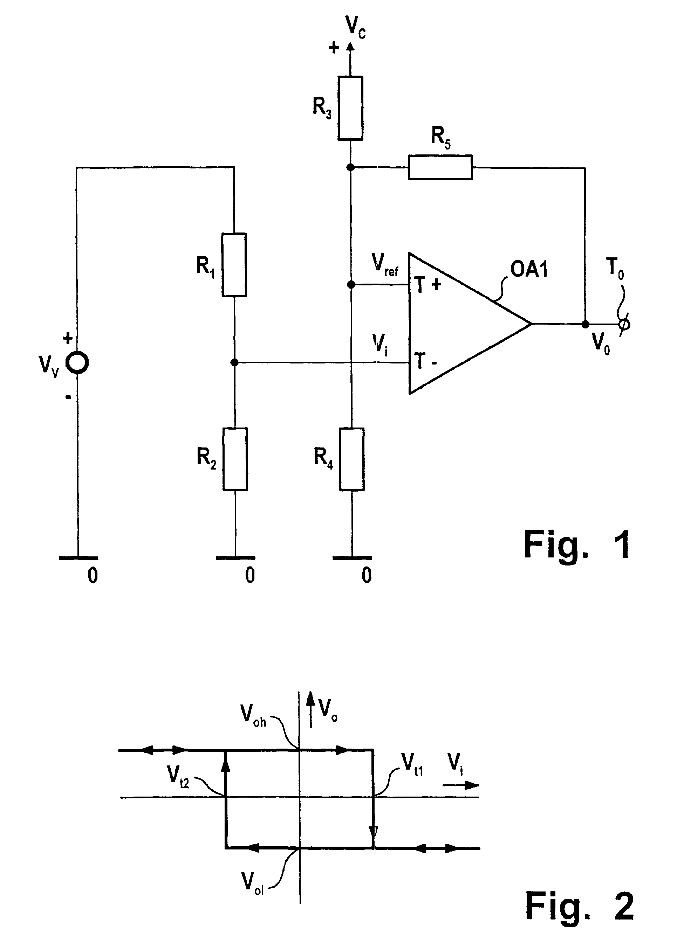

Figure 1 illustrates a conventional comparator circuit. As shown therein, the comparator circuit includes an operational amplifier, hereinafter also referred to as first operational amplifier OA1, having a differential input comprising an inverting and a non-inverting input terminal, T- and T+ respectively. The inverting and non-inverting input terminals, T- and T+, are being supplied with an input voltage Vi and a reference voltage Vref derived from a variable and a constant voltage source Vv and Vc through first and second voltage dividers, respectively. The first voltage divider comprises a serial arrangement of resistors R1 and R2, coupled between said variable voltage source Vv and mass, the common node of said resistors R1 and R2 constituting an output being coupled to the inverting input terminal T- of the operational amplifier OA1 to supply an input voltage Vi thereto. The second voltage divider comprises a serial arrangement of resistors R3 and R4, coupled between said constant voltage source Vc and mass, the common node of said resistors R1 and R2 constituting an output being coupled to the non-inverting input terminal T+ of the operational amplifier OA1 to supply a reference voltage Vref thereto. The output voltage Vo of the operational amplifier OA1 is positively fed back from an output terminal To through a resistor R5 to its non-inverting input terminal T+, therewith obtaining a Schmitt-Trigger type circuit. As known, dependent on the polarity of the differential voltage (Vref-Vi) between its non-inverting and inverting input terminals, T+ and T-, hereinafter also being referred to as differential input voltage, the operational amplifier OA1 is switched between two stable states, in which it provides mutually different output voltage levels, Vol and Voh. Switching from one state to the other occurs when the polarity of the differential input voltage (Vref-Vi) reverses, i.e. at zero crossings of this differential input voltage (Vref-Vi). These zero crossings mark the occurrence of equal levels of both input voltage Vi and reference voltage Vref. However, the above positive feedback causes the reference voltage Vref to change stepwise at any zero crossing of the differential input voltage (Vref-Vi), therewith giving rise to an hysteresis response, which is inherent to Schmitt-Trigger type comparator circuits.

Figure 2 shows the transfer characteristic of the known comparator from the input voltage Vi to an output voltage Vo at its output terminal To. Suppose at a large negative value for the input voltage Vi, i.e. at a large positive value of the differential input voltage (Vref-Vi), the operational amplifier OA1 is in its first state providing a high level output voltage Voh. A decrease of this large negative value of the input voltage Vi, causing said differential input voltage (Vref-Vi) to likewise decrease, does not change the state of the operational amplifier OA1, until this differential input voltage (Vref-Vi) crosses zero level, i.e. until this differential input voltage (Vref-Vi) reverses its polarity from positive into negative e.g. when the input voltage Vi crosses a first threshold level Vt1. Then the operational amplifier OA1 is switched into its second state providing a low level output voltage Vol. Any further increase of the magnitude of the differential input voltage (Vref-Vi) in this negative polarity does not change the state of the operational amplifier OA1. If the input voltage Vi is subsequently decreased, causing the magnitude of the differential input voltage (Vref-Vi) to likewise decrease in said negative polarity, the operational amplifier OA1 returns from its second state into its first state, when the differential input voltage (Vref-Vi) reverses its polarity from negative to positive again, i.e. when said differential input voltage (Vref-Vi) crosses zero level again, i.e. at a second threshold level Vt2. Because of the above positive feedback of the output voltage Vol of the operational amplifier to its non-inverting input terminal T+, said second threshold level Vt2 lies below the first threshold level Vt1. Any further increase of the magnitude of the differential input voltage (Vref-Vi) in this positive polarity does not change the state of the operational amplifier OA1.

It is clear that the output voltage level of the operational amplifier OA1 is ambiguous with respect to said input voltage Vi for values of the input voltage Vi between the first and second threshold levels Vt1 and Vt2. The narrower the hysteresis window, i.e. the range of the input voltage Vi between said first and second threshold levels Vt1 and Vt2, the more accurate the comparator is in detecting the level of the input voltage.

To narrow the hysteresis window in this known comparator and therewith increase the accuracy of level detection, the value of the resistor R5 should be orders of magnitude greater than the value of the resistors R3 and R4 of the second voltage divider. However, to obtain limited power consumption, the resistors R3 and R4 have to be very large in themselves. In a practical embodiment the value of the resistors R3 and R4 are in the order of magnitude of 500 KOhm, whereas the resistor R5 is in the order of magnitude of some Mohm. In car applications, parasitic effects due to e.g. damp and/or corrosion, may effect the resistor R5 to dramatically reduce its resistance value, therewith strongly increasing the switching window.

It is an object of the invention to introduce a degree of freedom in a comparator circuit allowing to combine limited power consumption with robust and highly accurate level detection.

A comparator circuit comprising a first operational amplifier having a differential input, first and second voltage dividers being coupled to respectively a variable and a constant voltage source, outputs thereof being coupled to said differential input for supplying a differential input voltage thereto, the first operational amplifier having an output being coupled to its differential input and providing an output voltage stepwise varying between first and second voltage levels at an inversion of the differential input voltage, according to the invention is therefore characterized by one of the first and second voltage dividers having a stepwise variable voltage dividing factor being controlled by the output voltage of the first operational amplifier to increase the magnitude of said differential input voltage by a step value upon such inversion of the differential input voltage.

The invention is based on the recognition that separation of the features of zero crossing signalling and determination of the hysteresis window, which in the known comparator are combined in the feedback resistor R5, removes the necessity of applying such high ohmic feedback resistor and therewith increases the robustness and reliability of the circuit as a whole, and additionally introduces a degree of freedom allowing to optimise the voltage dividers with respect to minimum power consumption on the one hand and accuracy in level detection on the other hand. By applying the measure according to the invention the output voltage of the first operational amplifier, carrying zero crossing information, is used amongst others as a switching control signal for a stepwise increase of the differential input voltage in its actual polarity, i.e. in the polarity of the differential input voltage after the initiating zero crossing. As a result thereof, a differential input voltage changing at a zero crossing in polarity from negative to positive is being increased by said step value to a more positive value, a differential input voltage changing at a zero crossing in polarity from positive to negative is being increased by said step value to a more negative value. By an appropriate step value the hysteresis window can be set at any wanted value, i.e. sufficiently small to obtain an appropriate accuracy in level detection and sufficiently large to avoid unwanted jitter at a frequently changing level of the input voltage Vi around the reference voltage Vref, from occurring.

Preferably, a comparator circuit according to the invention is characterized by said one of the first and second voltage dividers having a stepwise variable voltage dividing factor being constituted by a controlled voltage divider comprising a serial arrangement of a resistor and switched controlled resistor means, the common node thereof constituting an output of the controlled voltage divider, the switched controlled resistor means being controlled by the output voltage of the first operational amplifier to vary its resistance by a step value upon an inversion of the differential input voltage.

This measure allows to apply various alternative solutions for a stepwise increase of the differential input voltage at zero crossings of the differential input voltage of the operational amplifier in accordance with the invention

A first preferred embodiment of such comparator circuit is characterized in that the differential input of the first operational amplifier comprises an inverting and a non-inverting input terminal, the second voltage divider supplying a predetermined ratio of the output voltage of the constant voltage source to said non-inverting input terminal, the first voltage divider being constituted by said controlled voltage divider having said resistor and said switched controlled resistor means subsequently connected between the variable voltage source and mass, the output thereof being coupled to said inverting input terminal, the switched controlled resistor means being controlled by the output voltage of the first operational amplifier to increase its resistance by a step value upon an inversion of the differential input voltage caused by an increase of the voltage at the inverting input terminal above the voltage at the non-inverting input terminal.

By applying this measure, the input voltage at the inverting input terminal of the operational amplifier being defined by the voltage across the switched controlled resistor means, is increased by an increase of the resistance value of the switched controlled resistor means. A control thereof as mentioned above results in a stepwise increase of the differential input voltage at zero crossings of the differential input voltage of the operational amplifier in accordance with the invention.

A second preferred embodiment of a comparator circuit according to the invention is characterized in that the differential input of the first operational amplifier comprises an inverting and a non-inverting input terminal, the first voltage divider supplying a predetermined ratio of the output voltage of the variable voltage source to said inverting input terminal, the second voltage divider being constituted by said controlled voltage divider having said resistor and said switched controlled resistor means subsequently connected between the constant voltage source and mass, the output thereof being coupled to said non-inverting input terminal, the switched controlled resistor means being controlled by the output voltage of the first operational amplifier to decrease its resistance by a step value upon an inversion of the differential input voltage caused by an increase of the voltage at the inverting input terminal above the voltage at the non-inverting input terminal.

By applying this measure, the reference voltage at the non-inverting input terminal of the operational amplifier being defined by the voltage across the switched controlled resistor means, is decreased by a decrease in the resistance value of the switched controlled resistor means. A control thereof as mentioned above results in a stepwise increase of the differential input voltage at zero crossings of the differential input voltage of the operational amplifier in accordance with the invention.

A third preferred embodiment of a comparator circuit according to the invention is characterized in that the differential input of the first operational amplifier comprises an inverting and a non-inverting input terminal, the first voltage divider being constituted by said controlled voltage divider having said switched controlled resistor means and said resistor subsequently connected between the variable voltage source and mass, the output thereof being coupled to said inverting input terminal, the switched controlled resistor means being controlled by the output voltage of the first operational amplifier to decrease its resistance by a step value upon an inversion of the differential input voltage caused by an increase of the voltage at the inverting input terminal above the voltage at the non-inverting input terminal, the second voltage divider supplying a predetermined ratio of the output voltage of the constant voltage source to said non-inverting input terminal.

By applying this measure, the input voltage at the inverting input terminal of the operational amplifier being defined by the voltage across said resistor, is increased by a decrease in the resistance value of the switched controlled resistor means. A control thereof as mentioned above results in a stepwise increase of the differential input voltage at zero crossings of the differential input voltage of the operational amplifier in accordance with the invention.

A fourth preferred embodiment of a cornparator circuit according to the invention is characterized in that the differential input of the first operational amplifier comprises an inverting and a non-inverting input terminal, the first voltage divider supplying a predetermined ratio of the output voltage of the variable voltage source to said inverting input terminal, the second voltage divider being constituted by said controlled voltage divider having said switched controlled resistor means and said resistor subsequently connected between the constant voltage source and mass, the output thereof being coupled to said non-inverting input terminal, the switched controlled resistor means being controlled by the output voltage of the first operational amplifier to decrease its resistance by a step value upon an inversion of the differential input voltage caused by an increase of the voltage at the inverting input terminal above the voltage at the non-inverting input terminal.

By applying this measure, the reference voltage at the non-inverting input terminal of the operational amplifier being defined by the voltage across said resistor, is decreased by an increase in the resistance value of the switched controlled resistor means. A control thereof as mentioned above results in a stepwise increase of the differential input voltage at zero crossings of the differential input voltage of the operational amplifier in accordance with the invention.

A fifth preferred embodiment of a comparator circuit according to the invention is characterized in that the differential input of the first operational amplifier comprises an inverting and a non-inverting input terminal, the first voltage divider supplying a predetermined ratio of the output voltage of the variable voltage source to said non-inverting input terminal, the second voltage divider being constituted by said controlled voltage divider having said resistor and said switched controlled resistor means subsequently connected between the constant voltage source and mass, the output thereof being coupled to said inverting input terminal, the switched controlled resistor means being controlled by the output voltage of the first operational amplifier to increase its resistance by a step value upon an inversion of the differential input voltage caused by a decrease of the voltage at the non-inverting input terminal below the voltage at the inverting input terminal.

By applying this measure, the reference voltage at the inverting input terminal of the operational amplifier being defined by the voltage across said switched controlled resistor means, is increased by an increase in the resistance value of the switched controlled resistor means. A control thereof as mentioned above results in a stepwise increase of the differential input voltage at zero crossings of the differential input voltage of the operational amplifier in accordance with the invention. However, in this fifth alternative preferred embodiment the operational amplifier also provides inversion of its output voltage with respect to the before mentioned alternative preferred embodiments.

A sixth preferred embodiment of a comparator circuit according to the invention is characterized in that the differential input of the first operational amplifier comprises an inverting and a non-inverting input terminal, the first voltage divider being constituted by a first controlled voltage divider having a resistor and first switched controlled resistor means subsequently connected between the variable voltage source and mass, the output thereof being coupled to said non-inverting input terminal, the second voltage divider being constituted by a second controlled voltage divider having second switched controlled resistor means and a resistor subsequently connected between the constant voltage source and mass supplying a predetermined ratio of the output voltage of the constant voltage source to said inverting input terminal, the first and second switched controlled resistor means being controlled by the output voltage of the first operational amplifier to decrease their resistance by a step value upon an inversion of the differential input voltage caused by an decrease of the voltage at the non-inverting input terminal below the voltage at the inverting input terminal.

By applying this measure, both input and reference voltages at the respective inverting and non-inverting input terminals of the operational amplifier are respectively defined by the voltage across said first switched controlled resistor means and the resistor of said second controlled voltage divider. By a decrease in the resistance value of the switched controlled resistor means, a stepwise increase of the differential input voltage at zero crossings of this differential input voltage of the operational amplifier in accordance with the invention is obtained.

Preferably said switched controlled resistor means comprises a serial arrangement of a pair of resistors, one of which being shunted by a controllable switch. By closing said controllable switch said one resistor is being shortcircuited, resulting in a decrease in resistance value of the switched controlled resistor means and vice versa.

In another preferred embodiment of a comparator circuit according to the invention said switched controlled resistor means comprises a resistor coupled in parallel to a serial arrangement of a further resistor and a controllable switch. By closing the controllable switch said further resistor is being connected in parallel to the firstmentioned resistor, resulting in a decrease in resistance value of the switched controlled resistor means and vice versa.

Yet another preferred embodiment of a comparator according to the invention is characterized by said cascade of n operational amplifiers including said first operational amplifier having said first and second voltage dividers in common, the first voltage divider comprising a serial arrangement of first to (2n+1)^{th} resistors subsequently coupled between the variable voltage source and mass and having first to 2n^{th} outputs at the subsequent nodes between said resistors, the first to n^{th} outputs of the first voltage divider being coupled to the inverting inputs of the first to n^{th} operational amplifiers, respectively, the (n+1)^{th} to 2n^{th} outputs being shunted through first to n^{th} controllable switches, respectively, to mass, the second voltage divider supplying a predetermined ratio of the output voltage of the constant voltage source to the non-inverting input terminals of each operational amplifier.

Where the before mentioned embodiments allow to detect whether the input voltage level is below or above the reference voltage level with an acceptable uncertainty defined by the hysteresis window, this embodiment makes it possible to refine the detection of the input voltage level in n subsequent voltage ranges.

Preferably the switching devices used comprise switching transistors implemented in MOS technology, or more in particular CMOS technology. This measure allows for an integrated circuit implementation of the comparator according to the invention, requiring low supply current.

If power consumption in a quiescent mode is to a certain extend acceptable, then the switching devices may alternatively include a bipolar switching transistor.

To allow the comparator circuit to be used for in car applications, the constant and/or variable voltage source may preferably be temperature stabilised and/or provided with means for integrating interference pulses on the output voltage of both voltage sources.

The invention also relates to a voltage level detector comprising a comparator circuit as mentioned above.

These and further aspects and advantages of the invention will be discussed more in detail hereinafter with reference to the disclosure of preferred embodiments, and in particular with reference to the appended Figures in which like reference numerals refer to like elements wherein:
- Figure 1: is a schematic diagram of a conventional comparator circuit;
- Figure 2: shows a graph of input versus output voltage of a Schmitt-Trigger type comparator circuit, illustrating the system hysteresis window;
- Figure 3: is a schematic diagram of a first preferred embodiment of a comparator circuit according to the invention;
- Figure 4: is a schematic diagram of a second and/or third preferred embodiment of a comparator circuit according to the invention;
- Figure 5: is a schematic diagram of a fourth preferred embodiment of a comparator circuit according to the invention;
- Figure 6: is a schematic diagram of a fifth preferred embodiment of a comparator circuit according to the invention;
- Figure 7: is a schematic diagram of a sixth preferred embodiment of a comparator circuit according to the invention;
- Figure 8: is a schematic diagram of a seventh preferred embodiment of a comparator circuit according to the invention;
- Figure 9: is a schematic diagraim of a eighth preferred embodiment of a comparator circuit according to the invention providing 4-level detection of an input voltage.
- Figures 10a and 10b: are schematic diagrams of first and second alternative embodiments of controlled switching devices for use in a comparator circuit according to the invention;

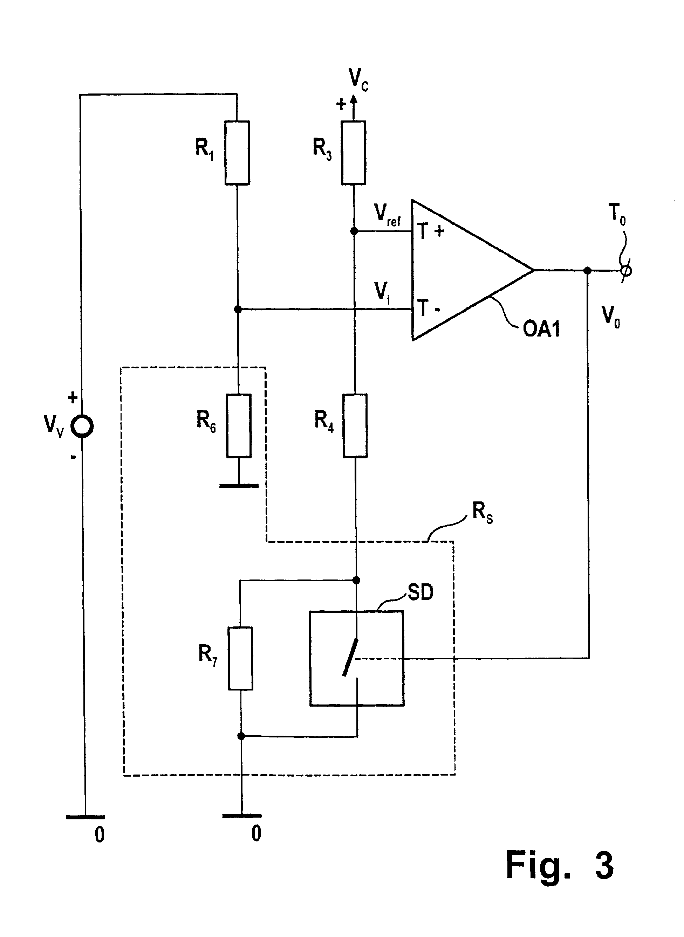

Figure 3 shows a first preferred embodiment of a comparator circuit according to the invention, in which - unlike the conventional comparator circuit of Figure 1 - the first voltage divider is constituted by a controlled voltage divider comprising a serial arrangement of the resistor R1 and switched controlled resistor means Rs coupled between the variable voltage source Vv and mass. The common node of the resistor R1 and the switched controlled resistor means Rs provides an output of the first voltage divider, which is coupled to the inverting input terminal T- of the first operational amplifier OA1 to supply the input voltage Vi thereto. The second voltage divider comprising a serial arrangement of resistors R3 and R4 coupled between the constant voltage source Vc and mass, supplies a fixed reference voltage Vref to the non-inverting input terminal T+ of the first operational amplifier OA1, Vref being a predetermined ratio R4/(R3+R4) of the output voltage of the constant voltage source Vc.

The switched controlled resistor means Rs is being controlled by the output voltage of the first operational amplifier OA1 to increase its resistance by a step value upon an inversion of the differential input voltage (Vref-Vi) caused by an increase of the input voltage Vi above the reference voltage Vref. For that purpose, the switched controlled resistor means Rs comprises a serial arrangement of a pair of resistors R6 and R7, the resistor R7 being shunted by a controllable switching device SD, which is controlled by the output voltage of the first operational amplifier OA1.

In the above first state, i.e. when the differential input voltage (Vref-Vi) has a positive value, i.e. Vi has a low value or equals mass potential, this output voltage attains a first voltage level, also being referred to as Voh, setting the controllable switching device SD in closed position, therewith shortcircuiting R7. The input voltage Vi is then defined by Vv.R6/(R1+R6). An increase of the output voltage level of the variable voltage source Vv will cause the differential input voltage (Vref-Vi) to decrease and does not change the state of the first operational amplifier OA1 until Vi exceeds above Vref, i.e. until the differential input voltage (Vref-Vi) crosses zero level and changes in polarity from positive to negative. At that point, the first operational amplifier OA1 is switched into its second state, providing an output voltage at a second voltage level, also being referred to as Vol, switching the controllable switching device SD from closed to open position. As a result thereof, the resistor R7 is inserted in the serial arrangement of R1 and R6, followed by a stepwise change in the voltage dividing factor of the first voltage divider from R6/(R1+R6) to (R6+R7)/(R1+R6+R7). This causes the input voltage level Vi to stepwise increase. The differential input voltage (Vref-Vi) therewith stepwise increases in the actual negative polarity. The voltage step value by which the differential input voltage (Vref-Vi) becomes more negative, is defined by the change in the dividing factor of the first voltage divider, i.e. by (R6+R7)/(R1+R6+R7) - R6/(R1+R6). The change in dividing factor therewith determines the width of the hysteresis window, i.e. the difference between the above first and second threshold levels Vt1 and Vt2.

The use of the output voltage of the first operational amplifier as a switching control signal for changing the dividing factor of the first voltage divider by a stepvalue, such that the differential input voltage (Vref-Vi) changing at a zero crossing in polarity from negative to positive is being increased by said step value to a more positive value, and the differential input voltage changing at a zero crossing in polarity from positive to negative is being increased by said step value to a more negative value, introduces a degree of freedom allowing to implement the features of zero crossing signalling and determination of the hysteresis window, which in the known comparator are combined in the feedback resistor R5, separately. This makes it possible to optimise the comparator circuit with respect to minimum power consumption by an appropriate choice of the values of the resistors R1, R6 and R7 of the first voltage divider and R3, R4 of the second voltage divider, and independent therefrom to optimise the hysteresis window with regard to maximum accuracy in level detection on the one hand and stabilisation of the output voltage level against jitter at frequent variations of the input voltage level Vi around the reference voltage Vref, on the other hand, by an appropriate ratio between the resistors R1, R6 and R7.

In a practical implementation of this first preferred embodiment, the resistors R1, R6 and R7 of the first voltage divider and R3, R4 of the second voltage divider were chosen to be 560kΩ, 100kΩ, 18kΩ and 680kΩ, 220kΩ, respectively. The first operational amplifier was implemented with IC type LM324 and the controllable switching device with switching module type 74HCT4066. The constant voltage source had an output level voltage of 5 Volt.

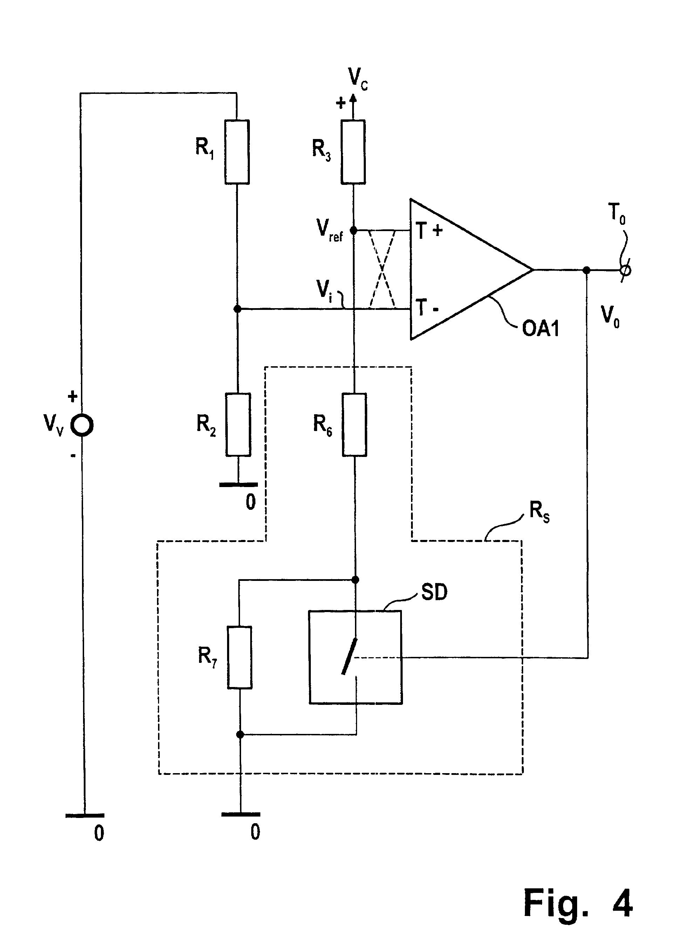

Figure 4 shows a comparator circuit according to the invention in a second preferred embodiment, in which the outputs of the first and second voltage dividers are respectively coupled to the inverting and non-inverting input terminal T- and T+ of the first operational amplifier OA1, and in a third preferred embodiment, in which the outputs of the first and second voltage dividers are coupled to said non-inverting and inverting input terminal T+ and T-, respectively, as indicated by dotted lines.

Unlike the previously discussed first preferred embodiment, the first voltage divider in the second and third preferred embodiments comprises a serial arrangement of resistors R1 and R2 coupled between the variable voltage source Vv and mass and providing at its output an input voltage level Vi for the first operational amplifier OA1 being a predetermined ratio of the output voltage of the variable voltage source Vv as defined by the ratio of resistance values R2/(R1+R2). The second voltage divider is being constituted by a controlled voltage divider corresponding to the one used in the first preferred embodiment and having the resistor R3 and said switched controlled resistor means Rs serially connected between the constant voltage source Vc and mass. The output voltage of the second voltage divider provides the reference voltage level Vref and is defined by the ratio of resistance values: R3/(R3+Rs). The switched controlled resistor means Rs corresponds to the one used in the first preferred embodiment and comprises a serial arrangement of the resistors R6 and R7, the resistor R7 being shunted by the controllable switching device SD and being controlled by the output voltage of the first operational amplifier OA1.

In the second preferred embodiment, the input voltage Vi and the reference voltage Vref are being supplied to the inverting and non-inverting input terminal T- and T+ of the first operational amplifier OA1, respectively. In the above first state, i.e. when the differential input voltage (Vref-Vi) has a high positive value, the output voltage Vo of the first operational amplifier OA1 attains the first voltage level, i.e. Voh, setting the controllable switching device SD in open position. The input voltage Vi is then defined by Vv.(R6+R7)/(R1+R6+R7). A decrease of the output voltage level of the variable voltage source Vv will cause the differential input voltage (Vref-Vi) to likewise decrease and does not change the state of the first operational amplifier OA1 until Vi exceeds above Vref, i.e. until the differential input voltage (Vref-Vi) crosses zero level and changes in polarity from positive to negative. At that point, the first operational amplifier OA1 is switched into its second state, providing an output voltage Vo at the second voltage level Vol, switching the controllable switching device SD from open to closed position. As a result thereof, the resistor R7 is shortcircuited, followed by a stepwise change in the voltage dividing factor of the second voltage divider from (R6+R7)/(R1+R6+R7) to R6/(R1+R6). This causes the reference voltage level Vref to stepwise decrease. The differential input voltage (Vref-Vi) therewith stepwise increases in the actual negative polarity. As in the first preferred embodiment, also here the voltage step value by which the differential input voltage (Vref-Vi) becomes more negative, is defined by the change in the dividing factor of the controlled voltage divider, in this second preferred embodiment being the second voltage divider, i.e. by (R6+R7)/(R1+R6+R7) - R6/(R1+R6), defining the width of the hysteresis window. In this second preferred embodiment the width of the hysteresis window is fixed and does not vary with a varying input voltage Vi.

In the third preferred embodiment, the input voltage Vi and the reference voltage Vref are being supplied to the non-inverting and inverting input terminal T+ and T- of the first operational amplifier OA1, respectively, being indicated in Figure 4 by dotted lines as already mentioned above. The switched controlled resistor means Rs of the second voltage divider is being controlled by the output voltage Vo of the first operational amplifier OA1 to increase its resistance by a step value upon an inversion of the differential input voltage (Vref-Vi) caused by a decrease of the input voltage Vi below the reference voltage Vref as will be described in more detail hereinafter.

When the input voltage Vi is highly positive, then the differential input voltage (Vref-Vi) is highly negative, setting the first operational amplifier OA1 in its second state. The output voltage Vo therewith attains the second voltage level Vol, setting the controllable switching device SD in closed position. The reference voltage Vref at the inverting input terminal T- of the first operational amplifier OA1 is then defined by Vc.R6/(R3+R6). A decrease of the output voltage level of the variable voltage source Vv will cause the differential input voltage (Vref-Vi) to likewise decrease and does not change the state of the first operational amplifier OA1 until the differential input voltage (Vref-Vi) crosses zero level and changes in polarity from negative to positive. At that point, the first operational amplifier OA1 is switched into its first state, providing an output voltage Vo at the first voltage level Voh, switching the controllable switching device SD from closed to open position. As a result thereof, the resistor R7 is inserted in serial arrangement with the resistor R6. This causes the voltage dividing factor of the second voltage divider to increase stepwise from R6/(R3+R6) to (R6+R7)/(R3+R6+R7) and along therewith the reference voltage Vref. The differential input voltage (Vref-Vi) therewith stepwise increases in the actual positive polarity. As in the first and second preferred embodiments, also here the voltage step value by which the differential input voltage (Vref-Vi) becomes more positive, is defined by the change in the dividing factor of the controlled voltage divider, in this third preferred embodiment being the second voltage divider, i.e. by (R6+R7)/(R1+R6+R7) - R6/(R1+R6) and defines the width of the hysteresis window. Also in this third preferred embodiment the width of the hysteresis window is fixed and does not vary with a varying input voltage Vi.

However, the output voltage Vo versus the input voltage Vi level variation of this third preferred embodiment is inverted with respect to the one in the first and second preferred embodiments.

In a practical implementation of this third preferred embodiment, the resistors R1 and R2 of the first voltage divider and R3, R6 and R7 of the second voltage divider were chosen to be 560kΩ and 100kΩ, 680kΩ, 220kΩ and 18kΩ, respectively. The first operational amplifier OA1 and the controllable switching device SD were implemented with IC type LM324 with switching module type 74HCT4066, respectively. The control of the switching module type 74HCT4066 by the output voltage Vo of the first operational amplifier OA1 had been reversed with respect to the one applied in the first preferred embodiment to set the controllable switching device SD in open position in the first state and in closed position in the second state. The constant voltage source Vc had an output level voltage of 5 Volt.

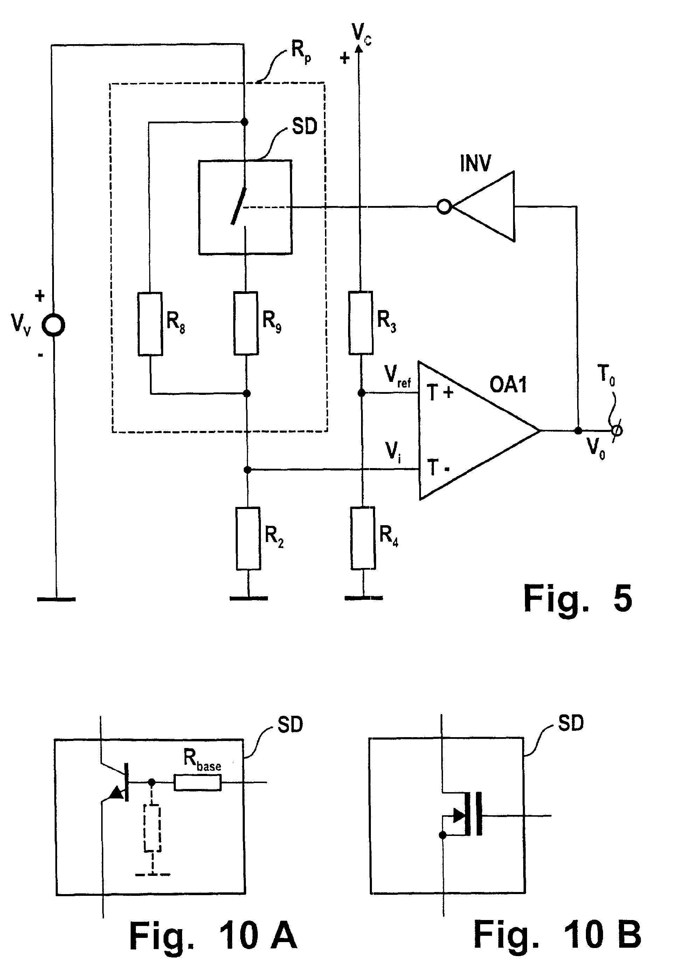

Figure 5 is a schematic diagram of a fourth preferred embodiment of a comparator circuit according to the invention, in which the second voltage divider comprises a serial arrangement of resistors R3 and R4 coupled between the constant voltage source Vc and mass, the common node of the resistors R3 and R4 providing an output of the second voltage divider supplying a fixed reference voltage Vref to the non-inverting input terminal T+ of the first operational amplifier OA1, Vref being a predetermined ratio R4/(R3+R4) of the output voltage of the constant voltage source Vc.

The first voltage divider is a controlled voltage divider having a serial arrangement of switched controlled resistor means Rp and resistor R2 subsequently connected between the variable voltage source Vv and mass, the common node thereof providing an output of the second voltage divider and supplying a varying input voltage to the inverting input terminal T- of the first operational amplifier OA1 being defined by Vv.R2/(Rp+R2). The switched controlled resistor means Rp comprises a resistor R8 being coupled in parallel to a serial arrangement of a further resistor R9 and a controllable switching device SD. In closed position of the controllable switching device SD, the resistance value of the switched controlled resistor means Rp is determined by the parallel connection of the resistors R8 and R9, i.e. by R8.R9/(R8+R9). In opened position of the controllable switching device SD, the resistance value of the switched controlled resistor means Rp is determined by the resistor R8, which is greater than the resistance value in closed position by the resistance step value R8 - R8.R9/(R8+R9), hereinafter being referred to as ΔRp.

The switched controlled resistor means Rp is being controlled by the output voltage of the first operational amplifier OA1 to decrease its resistance by a step value upon an inversion of the differential input voltage (Vref-Vi) caused by an increase of the input voltage Vi above the reference voltage Vref. As explained above this is obtained by switching the controllable switching device SD from opened to closed position.

In the first state of the first operational amplifier OA1 occurring when the differential input voltage (Vref-Vi) has a high positive value, this output voltage attains a first voltage level, i.e. Voh, setting the controllable switching device SD in open position, therewith inactivating the resistor R9. The input voltage Vi is then defined by Vv.R2/(R2+R8). An increase of the output voltage level of the variable voltage source Vv will cause the differential input voltage (Vref-Vi) to decrease and does not change the state of the first operational amplifier OA1 until Vi exceeds above Vref, i.e. until the differential input voltage (Vref-Vi) crosses zero level and changes in polarity from positive to negative. At that point, the first operational amplifier OA1 is switched into its second state, providing an output voltage at a second voltage level, e.g. Vol, switching the controllable switching device SD from open to closed position. As a result thereof, the resistor R9 is being connected in parallel to the resistor R8, followed by a stepwise increase in the voltage dividing factor of the first voltage divider by R2/(R2+R8-ΔRp). This causes the input voltage level Vi to stepwise increase with the same factor. Along therewith, the differential input voltage (Vref-Vi) increases in the actual negative polarity by a voltage step value defined by said increase in the voltage dividing factor of the first voltage divider, i.e. by Vv.R2/(R2+R8-ΔRp). This step voltage value is defined by the ratio in resistance values of the resistors R2, R8 and R9 and in its turn determines the width of the hysteresis window, i.e. the difference between the above first and second threshold levels Vt1 and Vt2. An implementation of the first operational amplifier OA1 by means of IC type LM 324 and switching device SD by means of switching module type 74HCT4066 requires an inverter device (not shown) to be inserted between such first operational amplifier OA1 and such switching device SD.

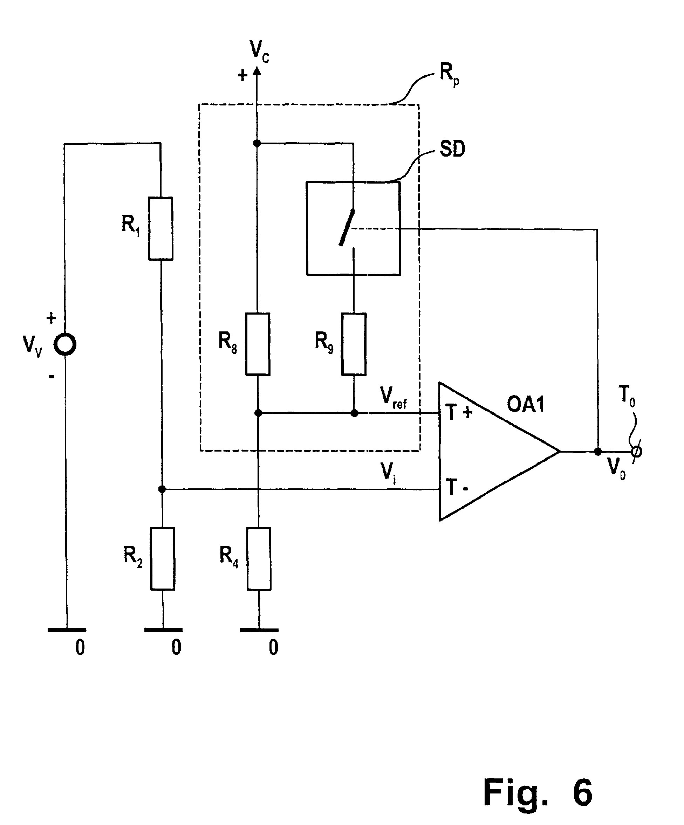

Figure 6 is a schematic diagram of a fifth preferred embodiment of a comparator circuit according to the invention, in which the first voltage divider comprises a serial arrangement of resistors R1 and R2 coupled between the variable voltage source Vv and mass. The common node of the resistors R1 and R2 provides an output of this first voltage divider supplying a variable input voltage Vi to the inverting input terminal T- of the first operational amplifier OA1, being a predetermined ratio R2/(R1+R2) of the output voltage of the variable voltage source Vv. The second voltage divider is a controlled voltage divider having a serial arrangement of switched controlled resistor means Rp and resistor R4 subsequently connected between the constant voltage source Vc and mass, the common node thereof providing an output of the second voltage divider and supplying a reference voltage Vref to the non-inverting input terminal T+ of the first operational amplifier OA1 being defined by Vc.R4/(Rp+R4). Also here, the resistance value of the switched controlled resistor means Rp decreases at the closing of the switching device SD by a stepvalue of ΔRp.

In this fifth preferred embodiment, the switched controlled resistor means Rp is being controlled by the output voltage Vo of the first operational amplifier OA1 to increase its resistance by the above step value upon an inversion of the differential input voltage (Vref-Vi) caused by an increase of the input voltage Vi above the reference voltage Vref, as will be explained in more detail hereinafter.

In the above state of the first operational amplifier OA1, i.e. when the differential input voltage (Vref-Vi) has a high positive value, the output voltage Vo of the first operational amplifier OA1 attains the first voltage level, e.g. Voh, setting the controllable switching device SD in closed position. The reference voltage Vref is then defined by Vc.R4/(R4 + (R8.R9/(R8+R9)). An increase of the output voltage level of the variable voltage source Vv will cause the differential input voltage (Vref-Vi) to decrease and does not change the state of the first operational amplifier OA1 until Vi exceeds above Vref, i.e. until the differential input voltage (Vref-Vi) crosses zero level and changes in polarity from positive to negative. At that point, the first operational amplifier OA1 is switched into its second state, providing an output voltage Vo at the second voltage level Vol, switching the controllable switching device SD from closed to open position. As a result thereof, the resistor R9 is inactivated, followed by a stepwise decrease in the voltage dividing factor of the second voltage divider from R4/(R4 + (R8.R9/(R8+R9)) to R4/(R4+R8). This causes the reference voltage level Vref to stepwise decrease too. Along therewith, the differential input voltage (Vref-Vi) increases in the actual negative polarity by a voltage step value defined by said decrease in the voltage dividing factor of the second voltage divider, i.e. by Vc.R4/(R4+R8-ΔRp). This step voltage value is defined by the ratio in resistance values of the resistors R4, R8 and R9 and in its turn determines the width of the hysteresis window, i.e. the difference between the above first and second threshold levels Vt1 and Vt2. In this fifth preferred embodiment the width of the hysteresis window is fixed and does not vary with a varying input voltage Vi.

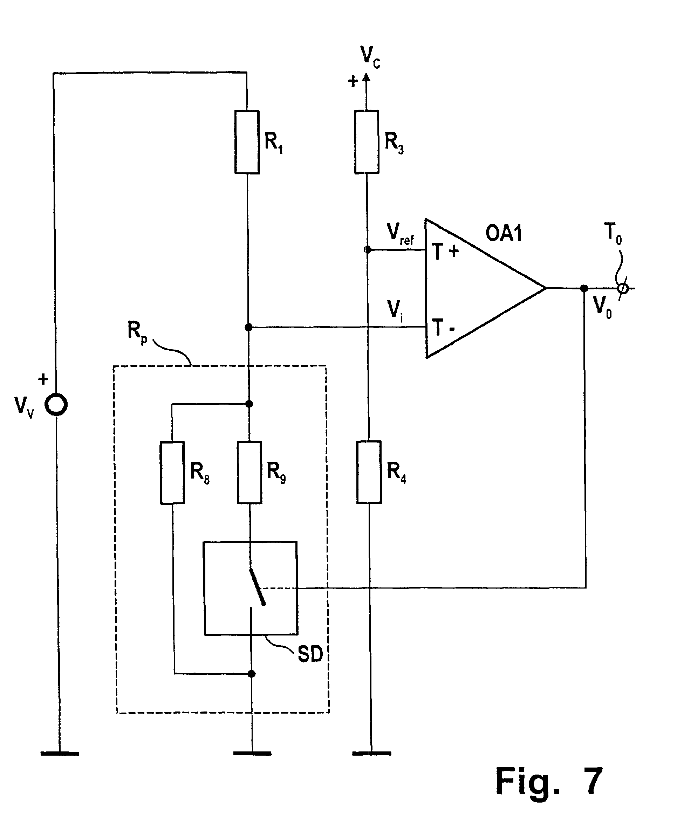

Figure 7 is a schematic diagram of a sixth preferred embodiment of a comparator circuit according to the invention in which the second voltage divider comprises a serial arrangement of resistors R3 and R4 coupled between the constant voltage source Vc and mass, the common node of the resistors R3 and R4 providing an output of the second voltage divider supplying a fixed reference voltage Vref to the non-inverting input terminal T+ of the first operational amplifier OA1, Vref being a predetermined ratio R4/(R3+R4) of the output voltage of the constant voltage source Vc.

The first voltage divider is a controlled voltage divider having a serial arrangement of resistor R2 and switched controlled resistor means Rp subsequently connected between the variable voltage source Vv and mass, the common node thereof providing an output of the second voltage divider and supplying a varying input voltage Vi to the inverting input terminal T- of the first operational amplifier OA1 being defined by Vv.R2/(Rp+R2). The switched controlled resistor means Rp comprises resistor R8 being coupled in parallel to a serial arrangement of resistor R9 and a controllable switching device SD. In closed position of the controllable switching device SD, the resistance value of the switched controlled resistor means Rp is determined by the parallel connection of the resistors R8 and R9, i.e. by R8.R9/(R8+R9). In opened position of the controllable switching device SD, the resistance value of the switched controlled resistor means Rp is determined by the resistor R8, which is greater than the resistance value in closed position by the resistance step value R8 - R8.R91(R8+R9), hereinafter being referred to as ΔRp. The resistance step value ΔRp determines the width of the hysteresis window.

The switched controlled resistor means Rp is being controlled by the output voltage of the first operational amplifier OA1 to decrease its resistance by a step value upon an inversion of the differential input voltage (Vref-Vi) caused by an increase of the input voltage Vi above the reference voltage Vref. As explained above this is obtained by the first operational amplifier OA1 switching the controllable switching device SD from closed to opened position.

In a practical implementation of this sixth preferred embodiment, the resistor R1 of the first voltage divider and R3 and R4 of the second voltage divider were chosen to be 560kΩ, 680kΩ and 220kΩ, respectively. The resistors R8 and R9 of the switched controlled resistor means Rp were chosen to be 100kΩ and iMΩ, respectively. The first operational amplifier OA1 and the controllable switching device SD were implemented with IC type LM324 with switching module type 74HCT4066, respectively.

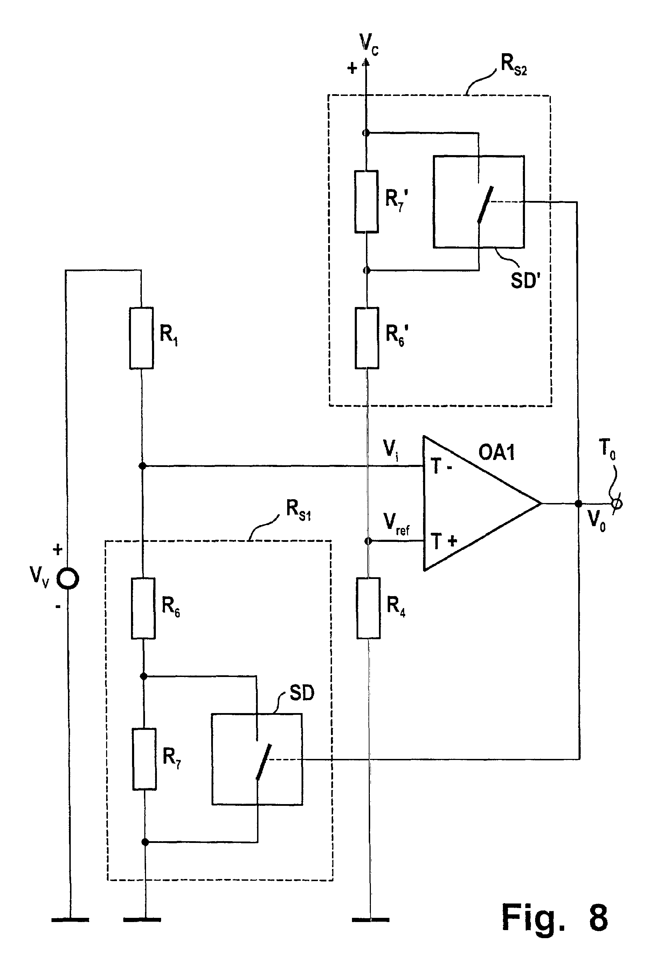

Figure 8 shows a comparator circuit according to the invention in a seventh preferred embodiment, in which the outputs of the first and second voltage dividers are respectively coupled to the non-inverting and inverting input terminals T+ and T- of the first operational amplifier OA1. The first and second voltage dividers are constituted by first and second controlled voltage dividers, respectively. The first voltage divider comprises the above resistor R1 and first switched controlled resistor means Rs1, subsequently connected in series between the variable voltage source Vv and mass. The second voltage divider comprises second switched controlled resistor means Rs2, and a resistor R4 subsequently connected in series between the constant voltage source Vc and mass supplying a predetermined ratio of the output voltage of the constant voltage source (Vc) to said inverting input terminal (T-). Both first and second switched controlled resistor means Rs1 and Rs2 correspond in circuitry to the above switched controlled resistor means Rs. The first switched controlled resistor means Rs1 comprises a serial arrangement of resistors R6 and R7, the resistor R7 being shunted by the controlled switching device SD. The second switched controlled resistor means Rs2 comprises a serial arrangement of resistors R6' and R7', the resistor R7' being shunted by the controlled switching device SD'. Upon an inversion of the differential input voltage (Vi-Vref) from postive to negative polarity caused by a decrease of the voltage Vi at the non-inverting input terminal T+ below the voltage Vref at the inverting input terminal T-, the output voltage of the first operational amplifier OA1 causes the controlled switching devices SD and SD' to simultaneously shortcircuit resistors R7 and R7'. As a result thereof differential input voltage (Vi-Vref) increase in negative polarity, i.e. becomes more negative, by a step value defining the hysteresis window. Dependent on the polarity of the various signals the use of inverters may be necessary to obtain the above functioning of the comparator in accordance with the invention.

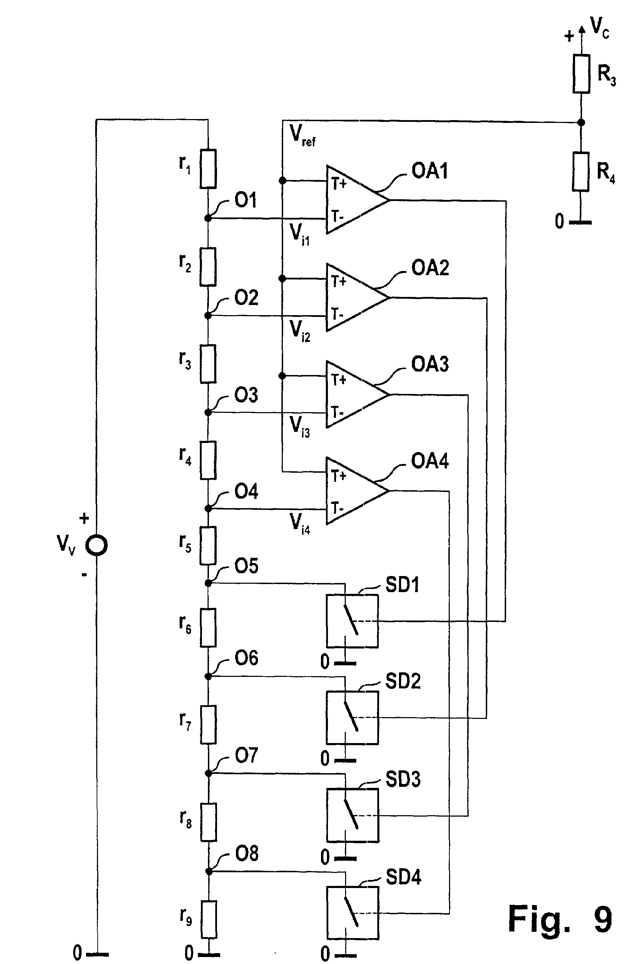

Figure 9 is a schematic diagram of a eighth preferred embodiment of a comparator circuit according to the invention comprising a cascade of first to fourth operational amplifiers OA1-OA4, the above mentioned first and second voltage dividers in common, the first voltage divider comprising a serial arrangement of first to ninth resistors r1 to r9 subsequently coupled between the variable voltage source Vv and mass and having first to eighth outputs O1-O8 at the subsequent nodes between said resistors r1-r9. The first to fourth outputs O1-O4 are coupled to the inverting inputs T-of the first to fourth operational amplifiers OA1-OA4, respectively. The fifth to eighth outputs O5-O8 are shunted through first to fourth controllable switching devices SD1-SD4, respectively, to mass. The second voltage divider comprises resistors R3 and R4 being serially coupled between the constant voltage source Vc and mass, supplying a reference voltage Vref to the non-inverting input terminals T+ of each of the first to fourth operational amplifiers OA1-OA4, this reference voltage Vref corresponding to Vc.R4/(R3+R4). This sixth preferred embodiment a comparator circuit according to the invention provides a 4-level detection of a varying input voltage Vi, as will be described in more detail hereinafter.

If the differential input voltage (Vref-Vi) has a high positive value, the operational amplifiers OA1-OA4 will assume the above first state and provide an output voltage at the above first voltage level, e.g. Voh, setting the controllable switching devices SD1-SD4 in closed position, therewith shortcircuiting r6-r9. The input voltages Vi1 to Vi4 of the operational amplifiers OA1-OA4 are then respectively defined by Vv.(r2+r3+r4+r5)/(r1+r2+r3+r4+r5); Vv.(r3+r4+r5)/(r1+r2+r3+r4+r5); Vv.(r4+r5)/(r1+r2+r3+r4+r5); Vv.r5/(r1+r2+r3+r4+r5). An increase of the output voltage level of the variable voltage source Vv will cause the differential input voltages (Vref-Vi1) to (Vref-Vi4) of the operational amplifiers OA1-OA4 to decrease and does not change the state of any of these operational amplifiers until Vi1 exceeds above Vref, i.e. until the differential input voltage (Vref-Vi1) of the first operational amplifiers OA1 crosses zero level and changes in polarity from positive to negative. At that point, the first operational amplifier OA1 is switched into its second state, providing an output voltage Vo1 at the second voltage level, e.g. Vol, switching the controllable switching device SD1 from closed to open position. As a result thereof, the resistor r6 is inserted in the serial arrangement of r1 to r5, followed by a stepwise change in the voltage dividing factor of the first voltage divider at the outputs O1-O4 from (r2+r3+r4+r5)/(r1+r2+r3+r4+r5); (r3+r4+r5)/(r1+r2+r3+r4+r5); (r4+r5)/(r1+r2+r3+r4+r5) and r5/(r1+r2+r3+r4+r5) to (r2+r3+r4+r5+r6)/(r1+r2+r3+r4+r5+r6); (r3+r4+r5+r6)/(r1+r2+r3+r4+r5+r6); (r4+r5+r6)/(r1+r2+r3+r4+r5+r6) and (r5+r6)/(r1+r2+r3+r4+r5+r6). This causes the input voltages Vi1 to Vi4 to stepwise increase. The differential input voltage (Vref-Vi1) therewith stepwise increases in the actual negative polarity. The voltage step value by which the differential input voltage (Vref-Vi1) becomes more negative, is defined by the change in the dividing factor of the first voltage divider and corresponds to Vv.(r2+r3+r4+r5+r6)/(r1+r2+r3+r4+r5+r6) - Vv.(r2+r3+r4+r5)/(r1+r2+r3+r4+r5). This voltage step value determines the width of the hysteresis window of the first operational amplifier OA1.

A further increase of the output voltage level of the variable voltage source Vv does not change the second state of the operational amplifiers OA1 and the first state of the operational amplifiers OA2-OA4 until Vi2 exceeds above Vref, i.e. until the differential input voltage (Vref-Vi1) of the second operational amplifiers OA2 crosses zero level and changes in polarity from positive to negative. At that point, the second operational amplifier OA2 is switched into its second state, providing an output voltage Vo2 at the second voltage level Vol, switching the controllable switching device SD2 from closed to open position. As a result thereof, the resistor r7 is inserted in the serial arrangement of r1 to r6, followed by a stepwise change in the voltage dividing factor of the first voltage divider at the outputs O1-O4 from (r2+r3+r4+r5+r6)/(r1+r2+r3+r4+r5+r6); (r3+r4+r5+r6)/(r1+r2+r3+r4+r5+r6); (r4+r5+r6)/(r1+r2+r3+r4+r5+r6) and (r5+r6)/(r1+r2+r3+r4+r5+r6) to (r2+r3+r4+r5+r6+r7)/(r1+r2+r3+r4+r5+r6+r7); (r3+r4+r5+r6+r7)/(r1+r2+r3+r4+r5+r6+r7); (r4+r5+r6+r7)/(r1+r2+r3+r4+r5+r6+r7) and (r5+r6+r7)/(r1+r2+r3+r4+r5+r6+r7). This causes the input voltages Vi1 to Vi4 to stepwise increase. The differential input voltage (Vref-Vi2) therewith stepwise increases in the actual negative polarity. The voltage step value by which the differential input voltage (Vref-Vi2) becomes more negative, is defined by the change in the dividing factor of the first voltage divider and corresponds to Vv.(r3+r4+r5+r6+r7)/(r1+r2+r3+r4+r5+r6+r7) - Vv.(r3+r4+r5+r6)/(r1+r2+r3+r4+r5+r6). This voltage step value determines the width of the hysteresis window of the second operational amplifier OA2.

The change of state of the operational amplifiers OA3 and OA4 follow in likewise manner upon a further increase of the output voltage level of the variable voltage source Vv.

Starting from a situation in which the operational amplifiers OA1-OA4 all are in the second state, a decrease of the output voltage level of the variable voltage source Vv, i.e. an decrease of the differential input voltages (Vref-Vi1) to (Vref-Vi4) will first cause the state of the fourth operational amplifier OA4 to return from the second state into the first state, followed at a further decrease of the output voltage level of the variable voltage source Vv, i.e. a further decrease of the differential input voltages (Vref-Vi1) to (Vref-Vi4), by the return of the third operational amplifier OA3 from the second into the first state, and so forth and so on.

By a proper choice of the values of the resistances r1-r9 four voltage detection levels can be obtained, evenly spread over the full input voltage variation range, while limiting power consumption. Unlike the above discussed preferred embodiments, where an input voltage Vi is compared with one single detection or voltage reference level and is differentiated into two voltage ranges (either below or above said voltage reference level Vref), this sixth preferred embodiment provides a differentiation of the input voltage Vi into five subsequent voltage ranges, reflected in the output voltages Vo1-Vo4 of the operational amplifiers OA1-OA4 and allowing for a more refined measuring of the level of the input voltage Vi.

By extending the number of operational amplifiers to in the cascade to n, the number of serially arranged resistors in the first voltage divider to (2n+1) and controllable switching devices to n, a differentiation of the input voltage Vi into n+1 subsequent voltage ranges is obtained.

Figure 10a shows a bipolar NPN transistor as a first alternative embodiment of the controlled switching device SD, having its base electrode coupled via a base resistor Rbase to the output of the first operational amplifier OA1. If used in the switched controlled resistor means Rs, then the collector-emitter path thereof is being shunted across the resistor R7. If used in the switched controlled resistor means Rp, then the collector-emitter path thereof is being serially connected to the resistor R9. In case of the use of the controlled switching device SD for switching through to the positive supply voltage a PNP transistor is to be used instead of the above NPN transistor.

Figure 10b shows a field effect CMOS transistor type BST82 as a second alternative embodiment of the controlled switching device SD, having its gate electrode coupled to the output of the first operational OA1. If used in the switched controlled resistor means Rs, then the drain-source path thereof is being shunted across the resistor R7. If used in the switched controlled resistor means Rp, then the drain-source path thereof is being serially connected to the resistor R9. In case of the use of the controlled switching device SD for switching through to the positive supply voltage a p-channel MOSFET has to be used instead of the above CMOS transistor type BST82, which is an n-channel MOSFET type.

The comparator according to the invention in the above preferred embodiments is generally applicable, however, is in particular suitable for use in car applications, such as a voltage detector providing e.g. an alert signal if the battery voltage is low or some crucial car feature needs servicing. In such application, improvement in the accuracy of level detection is obtained by a stabilisation of the constant and/or the variable voltage source and/or the output voltages of the first and second voltage dividers against temperature variations (not shown) and/or by an integration of interference pulses on the output voltage of both voltage sources (not shown). The implementation of these improvements are within the knowledge of the skilled man and needs no further amplification.

While the invention has been particularly shown and described with reference to the preferred embodiments thereof, it will be understood by those skilled in the art that various changes in form and details may be made without departing from the spirit and scope of the invention.

For instance, the use of the output voltage of the first operational amplifier OA1 as a switching control signal may necessitate to use inverters, switched controlled resistor means may be substituted for one or more of the resistors R1-R4 of the first and second voltage dividers, other than shown in the Figures, with an adequate adaptation the outputs of the first and second voltage dividers in the embodiments shown may well be coupled to the differential input of the operational amplifier opposite to the coupling shown, switched controlled resistor means Rs used in the first to third preferred embodiments may well be replaced by the switched controlled resistor means Rp of the fourth and fifth preferred embodiments and vice versa. Furthermore, the measure to invert the input voltage Vi versus output voltage Vo characteristic of the comparator as illustrated by way of example in the third preferred embodiment, may well be applied to the other preferred embodiments for the same purpose.

## Claims

1. Comparator circuit comprising a first operational amplifier (OA1) having a differential input (T+, T-), first and second voltage dividers being coupled to respectively a variable and a constant voltage source (Vv, Vc), outputs thereof being coupled to said differential input (T+, T-) for supplying a differential input voltage (Vref-Vi) thereto, the first operational amplifier (OA1) having an output (To) being coupled to its differential input (T+, T-) and providing an output voltage (Vo) stepwise varying between first and second voltage levels at an inversion of the differential input voltage (Vref-Vi), **characterised by** one of the first and second voltage dividers having a stepwise variable voltage dividing factor being controlled by the output voltage of the first operational amplifier (OA1) to increase the magnitude of said differential input voltage (Vref-Vi) by a step value upon such inversion of the differential input voltage (Vref-Vi).

2. Comparator circuit according to claim 1, **characterised by** said one of the first and second voltage dividers having a stepwise variable voltage dividing factor being constituted by a controlled voltage divider comprising a serial arrangement of a resistor (R1-R4) and switched controlled resistor means (Rs, Rp), the common node thereof constituting an output of the controlled voltage divider, the switched controlled resistor means (Rs, Rp) being controlled by the output voltage (Vo) of the first operational amplifier (OA1) to vary its resistance by a step value upon an inversion of the differential input voltage (Vref-Vi).

3. Comparator circuit according to claim 2, **characterised in that** the differential input (T+, T-) of the first operational amplifier (OA1) comprises an inverting (T-) and a non-inverting (T+) input terminal, the second voltage divider supplying a predetermined ratio of the output voltage of the constant voltage source (Vv) to said non-inverting input terminal (T+), the first voltage divider being constituted by said controlled voltage divider having said resistor (R1) and said switched controlled resistor means (Rs) subsequently connected between the variable voltage source (Vv) and mass, the output thereof being coupled to said inverting input terminal (T-), the switched controlled resistor means (Rs) being controlled by the output voltage of the first operational amplifier to increase its resistance by a step value upon an inversion of the differential input voltage (Vref-Vi) caused by an increase of the voltage (Vi) at the inverting input terminal (T-) above the voltage (Vref) at the non-inverting input terminal (T+).

4. Comparator circuit according to claim 2, **characterised in that** the differential input (T+, T-) of the first operational amplifier (OA1) comprises an inverting (T-) and a non-inverting input terminal (T+), the first voltage divider supplying a predetermined ratio of the output voltage of the variable voltage source (Vv) to said inverting input terminal (T-), the second voltage divider being constituted by said controlled voltage divider having said resistor (R3) and said switched controlled resistor means (Rs) subsequently connected between the constant voltage source (Vc) and mass, the output thereof being coupled to said non-inverting input terminal (T+), the switched controlled resistor means (Rs) being controlled by the output voltage (Vo) of the first operational amplifier (OA1) to decrease its resistance by a step value upon an inversion of the differential input voltage (Vref-Vi) caused by an increase of the voltage at the inverting input terminal (Vi) above the voltage at the non-inverting input terminal (Vref).

5. Comparator circuit according to claim 2, **characterised in that** the differential input (T+, T-) of the first operational amplifier (OA1) comprises an inverting (T-) and a non-inverting (T+) input terminal, the second voltage divider supplying a predetermined ratio of the output voltage of the constant voltage source (Vc) to said non-inverting input terminal (T+), the first voltage divider being constituted by said controlled voltage divider having said switched controlled resistor means (Rp) and said resistor (R2) subsequently connected between the variable voltage source (Vv) and mass, the output thereof being coupled to said inverting input terminal (T-), the switched controlled resistor means (Rp) being controlled by the output voltage (Vo) of the first operational amplifier (OA1) to decrease its resistance by a step value upon an inversion of the differential input voltage( Vref-Vi) caused by an increase of the voltage at the inverting input terminal (Vi) above the voltage at the non-inverting input terminal (Vref).

6. Comparator circuit according to claim 2, **characterised in that** the differential input (T+, T-) of the first operational amplifier (OA1) comprises an inverting (T-) and a non-inverting (T+) input terminal, the first voltage divider supplying a predetermined ratio of the output voltage of the variable voltage source (Vv) to said inverting input terminal (T-), the second voltage divider being constituted by said controlled voltage divider having said switched controlled resistor means (Rp) and said resistor (R4) subsequently connected between the constant voltage source (Vc) and mass, the output thereof being coupled to said non-inverting input terminal (T+), the switched controlled resistor means (Rp) being controlled by the output voltage (Vo) of the first operational amplifier (OA1) to increase its resistance by a step value upon an inversion of the differential input voltage (Vref-Vi) caused by an increase of the voltage at the inverting input terminal (Vi) above the voltage at the non-inverting input terminal (Vref).

7. Comparator circuit according to claim 2, **characterised in that** the differential input (T+, T-) of the first operational amplifier (OA1) comprises an inverting (T-) and a non-inverting (T+) input terminal, the first voltage divider supplying a predetermined ratio of the output voltage of the variable voltage source (Vv) to said non-inverting input terminal (T+), the second voltage divider being constituted by said controlled voltage divider having said resistor (R3) and said switched controlled resistor means (Rp) subsequently connected between the constant voltage source (Vc) and mass, the output thereof being coupled to said inverting input terminal (T-), the switched controlled resistor means (Rp) being controlled by the output voltage (Vo) of the first operational amplifier (OA1) to increase its resistance by a step value upon an inversion of the differential input voltage (Vref-Vi) caused by a decrease of the voltage at the non-inverting input terminal (Vi) below the voltage at the inverting input terminal (Vref).

8. Comparator circuit according to claim 2, **characterised in that** the differential input (T+, T-) of the first operational amplifier (OA1) comprises an inverting (T-) and a non-inverting (T+) input terminal, the first voltage divider being constituted by a first controlled voltage divider having a resistor (R1) and first switched controlled resistor means (Rs1) subsequently connected between the variable voltage source (Vv) and mass, the output thereof being coupled to said non-inverting input terminal (T+), the second voltage divider being constituted by a second controlled voltage divider having second switched controlled resistor means (Rs2) and a resistor (R4) subsequently connected between the constant voltage source (Vc) and mass supplying a predetermined ratio of the output voltage of the constant voltage source (Vc) to said inverting input terminal (T-), the first and second switched controlled resistor means (Rs1 and Rs2) being controlled by the output voltage of the first operational amplifier to decrease their resistance by a step value upon an inversion of the differential input voltage (Vi-Vref) caused by an decrease of the voltage (Vi) at the non-inverting input terminal (T+) below the voltage (Vref) at the inverting input terminal (T-).

9. Comparator circuit according to one of claims 2 to 8, **characterised in that** said switched controlled resistor means (Rs) comprises a serial arrangement of a pair of resistors (R6, R7, R6', R7'), one of which (R7, R7') being shunted by a controllable switching device (SD).

10. Comparator circuit according to one of claims 2 to 8, **characterised in that** said switched controlled resistor means (Rp) comprises a resistor (R8) coupled in parallel to a serial arrangement of a further resistor (R9) and a controllable switching device (SD).

11. Comparator circuit according to one of claims 2 to 4, **characterized by** said cascade of n operational arnplifiers (OA1-OAn) including said first operational amplifier (OA1) having said first and second voltage dividers in common, the first voltage divider comprising a serial arrangement of first to (2n+1)^{th} resistors (r1-r2n+1) subsequently coupled between the variable voltage source (Vv) and mass and having first to 2n^{th} outputs (O1-O2n) at the subsequent nodes between said resistors (r1-r2n+1), the first to n^{th} outputs (O1-On) of the second voltage divider being coupled to the inverting inputs (T-) of the first to n^{th} operational amplifiers (OA1-Oan), respectively, the (n+1)^{th} to 2n^{th} outputs (On+1-O2n) being shunted through first to n^{th} controllable switching devices (SD1-SDn), respectively, to mass, the second voltage divider supplying a predetermined ratio of the output voltage of the constant voltage source (Vref) to the non-inverting input terminals (T+) of each operational amplifier (OA1-OAn).

12. Comparator circuit according to one of claims 9 to 11, **characterised in that** each said switching device (SD, SD1-SDn) comprises a switching transistor (FET1) implemented in MOS technology.

13. Comparator circuit according to one of claims 9 to 11, **characterised in that** each said switching device (SD, SD1-SDn) comprises a bipolar switching transistor (Tr).

14. Comparator circuit according to one of claims 9 to 11, **characterised in that** each said switching device (SD, SD1-SDn) comprises a transistor (FET2) implemented in MOS technology.

15. Voltage level detector comprising a comparator circuit according to one of claims 1 to 14, **characterised in that** the constant voltage source (Vc) is temperature stabilised.

16. Voltage level detector according to claim 15, **characterised by** an integration of interference pulses on the output voltage of both voltage dividers (Vref, Vi1-Vi4).
